Europäisches Patentamt

European Patent Office

Office européen des brevets

(19)

(11) Veröffentlichungsnummer: **0 432 465 A2**

(12) **EUROPÄISCHE PATENTANMELDUNG**

(21) Anmeldenummer: 90121533.5

(22) Anmeldetag: **10.11.90**

(51) Int. Cl.5 **G03F 7/28,** G03C 7 12, G02F 1/133

(30) Priorität: **16.11.89 DE 3938112**

(43) Veröffentlichungstag der Anmeldung:
**19.06.91 Patentblatt 91/25**

(84) Benannte Vertragsstaaten:
**BE DE FR GB IT NL**

(71) Anmelder: **DU PONT DE NEMOURS
(DEUTSCHLAND) GMBH**
**Du Pont Strasse 1**
**W-6380 Bad Homburg(DE)**

(72) Erfinder: **Grossa, Mario, Dr.**
**Am Geisberg 21**
**W-6072 Dreieich(DE)**

(54) **Verfahren zur Herstellung von optischen Farbfiltern.**

(57) Farbfilter, die durch Auftragen eines farbmittel-haltigen Tonerpulvers auf eine bildmäßig belichtete negativ arbeitende lichtempfindliche tonbare Schicht erzeugt werden, zeigen starke Lichtstreuung und sind daher in Helligkeit und Farbkontrast unbefriedigend. Man verwendet schmelzbare oder thermoplastische Tonerpulver und unterzieht die Schicht nach dem Auftragen einer Wärmebehandlung, vorzugsweise unterhalb 240 °C, wobei die schichtbildende Zusammensetzung sich fast vollständig verflüchtigt.

EP 0 432 465 A2

## VERFAHREN ZUR HERSTELLUNG VON OPTISCHEN FARBFILTERN

Die Erfindung betrifft ein Verfahren zur Herstellung von beliebig gemusterten ein- oder mehrfarbigen optischen Farbfiltern, wie sie beispielsweise zur Farbtrennung in Geräten zur Aufnahme von farbigen Bildern oder insbesondere auch in Anordnungen zur Wiedergabe solcher Bilder (Displays) verwendet werden.

Solche Farbfilter sind meist fein gemustert, d.h. die Strukturelemente sind häufig nur einige $\mu m$ groß Je nach der Anwendung haben diese Elemente die Form von Streifen, Kreisen oder anderen geometrischen Figuren. Meist werden Filter verlangt, bei denen Bereiche mit verschiedenen Farben dicht nebeneinander angeordnet sind.

Es ist eine große Zahl von Verfahren bekannt, mit denen sich solche Farbfilter herstellen lassen. Die dabei angewandten Techniken umfassen Siebdruck, Farbphotographie auf Silberhalogenidbasis, Diazoverfahren, Übertragung vorgeformter verschiedenfarbiger Muster auf ein gemeinsames Substrat, bildmäßige Abtragung gefärbter Schichten durch Laser oder durch Auswaschen nach Photovernetzung, Einfärben von lithographisch geformten Mustern aus farblosen Bindemitteln und andere.

Ebenfalls bekannt sind Verfahren, bei denen feinverteilte Farbstoffe oder auch gefärbte Zubereitungen in Form des gewünschten Musters auf das Substrat aufgetragen werden. So wird in den EP 01 13 237 und EP 01 57 486 vorgeschlagen, auf einem isolierenden Substrat zunächst eine gemusterte leitfähige Schicht zu erzeugen und danach auf die leitfähigen Bereiche elektrophoretisch aus einer wäßrigen, ein Polymer und einen Farbstoff enthaltenden Lösung eine gefärbte Polymerschicht aufzutragen. Verschiedene voneinander isolierte leitfähige Bereiche lassen sich in geeigneten Elektrophoresebädern nacheinander mit Beschichtungen verschiedener Farbe versehen. Wenn die leitfähigen Bereiche später in einer Flüssigkristallzelle als Elektroden dienen sollen, dann wird jedoch das elektrische Feld durch die Polymerschicht teilweise abgeschirmt, wodurch sich die Empfindlichkeit der Zelle vermindert.

Aus den Patentschriften DE 27 58 209 und DE 34 29 615 sind negativ arbeitende lichtempfindliche Schichten bekannt, bei denen die belichteten Bereiche zur Erzeugung eines Bildes mit einem farbigen Pulver tonbar sind. Die dort beschriebenen Schichten können auch Weichmacher enthalten. Die Verwendung negativ arbeitende Schichten bietet für mehrfarbige Muster den Vorteil, daß die im ersten Schritt unbelichteten und nicht getonten Bereiche ihre Lichtempfindlichkeit behalten und in einem folgenden Schritt nach Aufbelichtung eines weiteren Musters mit einer anderen Farbe getont werden können. Dieser Vorgang kann solange wiederholt werden, bis die gesamte Schicht getont ist. Nach diesem Verfahren auf transparenten Trägern hergestellte Muster sind jedoch nicht als Farbfilter geeignet, da sie das Licht sehr stark streuen. Außerdem sind sie gegenüber vielen Lösungsmitteln unbeständig, sodaß die weitere Verarbeitung zu Flüssigkristallzellen, z.B. das Aufbringen von Ausgleichsschichten aus Lösungsmitteln, nur mit Einschränkungen möglich ist.

Die Erfindung stellt sich die Aufgabe, ein Verfahren anzugeben, mit dem auf einfache Weise Farbfilter geringer Lichtstreuung und guter Beständigkeit gegen mechanische und chemische Einflüsse unter Verwendung negativ arbeitender lichtempfindlicher tonbarer Schichten hergestellt werden können.

Diese Aufgabe wird gelöst durch ein Verfahren zur Herstellung von ein- oder mehrfarbigen Farbfiltern, bestehend aus den Schritten

a) Aufbringen einer negativ arbeitenden lichtempfindlichen tonbaren Schicht auf einen transparenten Träger,

b) bildmäßige Belichtung mit einem Muster, welches der räumlichen Anordnung der Filterelemente einer Farbe entspricht,

c) Tonen der Schicht mit einem farbigen Toner,

d) ggf. Wiederholen von b) und c) mit Mustern, welche der räumlichen Anordnung der Filterelemente weiterer Farben entsprechen, unter Verwendung von Tonern der zugehörigen Farben,

welches dadurch gekennzeichnet ist, daß

1. die lichtempfindliche tonbare Schicht aus einer Zusammensetzung gebildet wird, die sich bei der Wärmebehandlung nach 3. nahezu vollständig verflüchtigt,

2. farbige Toner verwendet werden, die entweder Pulver schmelzbarer oder thermoplastischer Farbmittel sind oder neben einem Farbmittel ein thermoplastisches Bindemittel enthalten und daß

3. die ggf. mehrfach belichtete und getonte Schicht einer Wärmebehandlung unterzogen wird.

Zur Ausführung des erfindungsgemäßen Verfahrens eignen sich vorzugsweise negativ arbeitende lichtempfindliche Schichten mit 1,4-Dihydropyridinverbindungen, wie sie beispielsweise in den Patentschriften DE 27 58 209 und DE 34 29 615 beschrieben sind. Bevorzugt werden 2'-Nitrophenyl-1,4-dihydropyridinverbindungen, z.B. die auf Seite 3, Zeilen 51 bis 60 der DE 34 29 615 genannten Verbindungen. Diese Verbindungen können für sich allein oder in Mischung miteinander entweder in reiner Form oder auch in einem flüchtigen Lösungsmittel gelöst mit Hilfe eines üblichen Beschichtungsverfahrens, beispielsweise Schleuderbeschichtung, auf den transparenten Träger aufgetragen werden.

Die lichtempfindlichen Schichten können auch aus 1,4-Dihydropyridinen im Gemisch mit Hexaarylbisimidazolen hergestellt werden. Geeignete Verbindungen sind in den Tabellen I und II der DE 27 58 209 aufgeführt.

Die lichtempfindliche Schichten können Weichmacher enthalten, die mit dem Bindemittel des Toners verträglich sind. Geeignete Weichmacher sind beispielsweise Ester aus aliphatischen oder aromatischen Di-, Tri- und Tetracarbonsäuren mit 2 bis 14 Kohlenstoffatomen und monofunktionellen Alkoholen mit 1 bis 20 Kohlenstoffatomen, Ester aus di-, tri- oder tetrafunktionellen Alkoholen mit 2 bis 20 Kohlenstoffatomen und aliphatischen oder aromatischen Monocarbonsäuren mit 4 bis 12 Kohlenstoffatomen sowie Ether aus einem der genannten polyfunktionellen Alkohole mit den genannten monofunktionellen Alkoholen. Beispielhaft seien Diisobutylphthalat, Dibutyladipat, Dibutylglykol und Trioctylmellitat genannt. Die notwendige Menge an Weichmacher kann durch Versuche ermittelt werden; sie beträgt im allgemeinen zwischen 2 und 15 Gewichtsprozent des Trockenanteils der lichtempfindlichen Schicht. Bei gewissen Kombinationen von lichtempfindlicher Substanz und Tonerbindemittel, z.B. Dihydropyridinverbindungen, insbesondere 2'-Nitrophenyldihydro-pyridinderivate, bevorzugt Ester der 2'-Nitrophenyl-1,5-di-hydropyridin-3,5-dicarbonsäure und Celluloseacetat, Polymethylmethacrylat oder Poly-α-methylstyrol erhält man auch ohne eine besonderen Weichmacher bereits befriedigende Ergebnisse. Es wird angenommen, daß in diesem Fall die lichtempfindliche Substanz selbst bzw. ihre Photolyseprodukte gleichzeitig als Weichmacher wirken. Die Weichmacher sind dann also erst nach der bildmäßigen Belichtung in der Schicht vorhanden. Daher wird bei solchen Systemen bevorzugt vor der Wärmebehandlung noch eine vollflächige Belichtung durch den transparenten Träger auf die Rückseite der getonten lichtempfindlichen Schicht durchgeführt, um die Menge des Weichmachers in der Schicht zu erhöhen.

Es ist nicht zwingend notwendig, den lichtempfindlichen Schichten hochmolekulare Verbindungen als Bindemittel zuzusetzen. Die Haftung der erfindungsgemäß hergestellten Filterbereiche auf dem Träger ist im allgemeinen auch ohne Bindemittel ausreichend.

Die Dicke der lichtempfindlichen Schicht kann in gewissen Grenzen frei gewählt werden. Dabei ist zu berücksichtigen, daß dickere Schichten ein geringeres Auflösungsvermögen haben, während dünnere Schichten zu geringeren Farbdichten führen. Gute Ergebnisse erhält man im allgemeinen mit Schichten von 0.5 bis 5 µm Dicke.

Die erfindungsgemäß anzuwendenden Toner enthalten notwendigerweise Farbmittel (Pigmente oder Farbstoffe), die nach den gewünschten Eigenschaften der Farbfilter ausgewählt werden können. Geeignete Farbmittel sind zum Beispiel in der DE 29 45 564 auf Seite 5, Zeile 57 ff. genannt. Vorteilhafterweise enthalten die Toner darüber hinaus ein thermoplastiches Bindemittel, welches ggf.mit dem Weichmacher der lichtempfindlichen Schicht verträglich sein muß. Hierfür eignen sich beispielsweise Polyvinylchlorid, Polyvinylalkohol, Polystyrol, Vinylchlorid-Vinylacetat-Copolymere; bevorzugt werden Celluloseacetate, Poly-α-methylstyrol und Polymethylmethacrylat. Wenn als Bindemittel für die Toner Polyamidsäuren eingesetzt werden, dann ergeben sich durch die nachfolgende Wärmebehandlung infolge der Umsetzung zu Polyimiden mechanisch und chemisch sehr widerstandsfähige Filterelemente. Wenn das Farbmittel selbst ohne Zersetzung schmelzbar oder thermoplastisch ist, braucht der Toner kein Bindemittel zu enthalten. Die Toner werden in Form von Pulvern angewandt, deren Teilchen zwischen 0,2 und 30 µm groß sind und bei denen vorteilhafterweise mindestens 50 °∘ der Teilchen äquivalente Kugeldurchmesser zwischen 2 und 10 µm haben.

Es können auch solche Toner verwendet werden, die für elektrostatische Kopierverfahren mit thermischer Fixierung bestimmt sind.

Zur Herstellung der Farbfilter nach dem erfindungsgemäßen Verfahren wird auf die auf dem transparenten Träger befindliche lichtempfindliche Schicht durch eine geeignete Maske ein Muster in der Form der gewünschten Filterelemente einer Farbe aufbelichtet und mit dem entsprechend gefärbten Tonerpulver getont. Dieses Tonen kann nach verschiedenen bekannten Methoden, z.B. mit einem Wattebausch oder mit einem Pinsel, durch Aufstreuen und Abrieselnlassen, ggf. unter Vibrieren des Trägers, oder durch Berührung mit einer Hilfsoberfläche, an die das Tonerpulver nur lose gebunden ist, geschehen. Das Muster kann auch mit Hilfe einer farbmittelhaltigen Übertragungsschicht, z.B. nach den Patentschriften DE 29 49 462 oder DE 36 25 014, eingefärbt werden, indem man die lichtempfindliche Schicht mit der Übertragungsschicht, ggf. unter Anwendung von Druck und Wärme, in Berührung bringt und wieder von ihr trennt. Diese Arbeitsschritte des Belichtens und Tonens sind für jede einzelne Farbe zu wiederholen.

In vielen Fällen ist es erforderlich, daß neben den Farbfilterbereichen auf dem Träger auch noch unbunte, stark lichtschwächende Bereiche vorhanden sind, die eine sog. schwarze Matrix bilden. Eine solche Matrix läßt sich ähnlich wie die Filterelemente durch Aufbelichten eines Musters und Tonen mit einem Toner, der ein schwarzes Farbmittel enthält, herstellen. Dies geschieht vorzugsweise in einem ersten Schritt vor der Erzeugung der Farbfilter.

Lichtempfindliche Schichten mit Dihydropyridinen werden vorteilhaft nach jedem Tonen mit einer starken Säure behandelt, wie dies in der DE 35 40 804 beschrieben ist. Hierdurch wird vermieden, daß die mit einer bestimmten Farbe eingefärbten Bereiche beim nachfolgenden Tonen mit einer anderen Farbe durch diese verunreinigt werden.

Wenn alle gewünschten Farben aufgetragen sind, wird das System aus Träger, lichtempfindlicher Schicht und musterartig aufgetragenen Tonern einer Wärmebehandlung unterzogen. Dadurch wird zweierlei erreicht: Erstens verflüchtigt sich der flüchtige Anteil der lichtempfindlichen Schicht, die nun nicht mehr gebraucht wird und die Eigenschaften des fertigen Displays nachteilig beeinflussen könnte. Zum anderen kommt es zu einer Koaleszenz der Tonerteilchen und die Filterelemente verlieren die störende Eigenschaft der starken Lichtstreuung zum größten Teil. Außerdem werden die Filterelemente durch die Wärmebehandlung wesentlich beständiger gegenüber den bei der weiteren Bearbeitung verwendeten Lösungsmittel wie beispielsweise Phenoxyethanol oder N-Methylpyrrolidon.

Die Wärmebehandlung wird bei einer möglichst niedrigen Temperatur, bevorzugt unterhalb von 240 °C durchgeführt. Ihre Dauer beträgt vorzugsweise 10 bis 60 min. Temperatur und Dauer der Wärmebehandlung sind jedoch stets so zu wählen, daß keine merkliche Zersetzung des Träger- und Tonermaterials eintritt.

Es ist nicht völlig klar, warum durch die Wärmebehandlung eine so starke Verminderung der Lichtstreuung in den getonten Filterelementen auftritt. Man kann annehmen, daß durch die Koaleszenz der Tonerpulverteilchen die Zahl der streuenden Grenzflächen drastisch vermindert wird. Es ist jedoch überraschend, daß es nicht darauf ankommt, ob die Tonerteilchen tatsächlich schmelzen. Die erfindungsgemäße Wirkung wird sowohl dann beobachtet, wenn der Toner nur solche Farbmittel und Bindemittel enthält, die bei der Temperatur der Wärmebehandlung nicht schmelzen können, als auch dann, wenn das polymere Bindemittel des Toners einen Schmelzpunkt hat, der niedriger als diese Temperatur ist. Ebenfalls überraschend ist es, daß bei der Ausführung des erfindungsgemäßen Verfahrens keine merkliche Veränderung in der Form der Filterelemente auftritt. Dies gilt ebenfalls unabhängig davon, ob der Toner Komponenten enthält, die bei der Temperatur der Wärmebehandlung schmelzen.

Bei einer besonders vorteilhaften Ausgestaltung des erfindungsgemäßen Verfahrens kann die Lichtstreuung der Filterelemente noch weiter vermindert werden. Hierzu setzt man das fertige Filter nach der Wärmebehandlung einem Lösungsmittel aus, welches nach den Eigenschaften des Tonerbindemittels ausgewählt wird. Bei Celluloseacetatonern erhält man gute Ergebnisse mit Aceton. Geeignet sind auch Butanon und Dichlormethan. Vorzugsweise wird das Lösungsmittel in Dampfform angewendet.

Die erfindungsgemäß hergestellten Farbfilter haben, da sie aus einzelnen, nebeneinander auf dem Träger haftenden verschiedenfarbigen Bereichen bestehen, im allgemeinen keine völlig ebene Oberfläche. Sie können jedoch auf einfache Weise mit einer Ausgleichsschicht aus Polyimid beschichtet werden, indem man eine Lösung des Polyimids in einem geeigneten Lösungsmittel, beispielsweise Phenoxyethanol, aufträgt und trocknet. Eine solche Schicht wird als sog. Orientierungsschicht in LC-Displays ohnehin benötigt. In einer anderen Ausführungsform kann auf diese Schicht noch eine gemusterte leitfähige Schicht, beispielsweise aus Indium-Zinn-Oxid, aufgetragen werden, die als Steuerelektrode im Display dient.

Das erfindungsgemäße Verfahren zeichnet sich gegenüber dem Stand der Technik dadurch aus, daß es einfach und mit geringem Aufwand durchgeführt werden kann. So wird beispielsweise nur eine lichtempfindliche Schicht benötigt. Besondere Maßnahmen zur Sicherung der Dimensionsstabilität, wie sie bei Übertragungsverfahren notwendig sind, entfallen, da die farbigen Filterelemente direkt auf dem Träger erzeugt werden. Der Farbort der Filterelemente kann durch Auswahl des Farbmittels oder auch durch einfaches Abmischen verschiedener Toner an den Zielwert angepaßt werden. Auch die Farbdichte läßt sich auf einfache Weise steuern, beispielsweise durch die Belichtung.

Die erfindungsgemäß hergestellten Farbfilter sind hervorragend zum Einbau in Flüssigkristall-Displays geeignet. Sie sind maßgenau, von sehr gleichmäßiger Schichtdicke und mit den beim Einbau einwirkenden Materialien und Lösungsmitteln verträglich. Da die Art der Farbmittel in weiten Grenzen frei wählbar ist, kann man Pigmente mit hoher Alterungsbeständigkeit anwenden. Die geringe Streuung der Filterelemente bedingt einen hohen Kontrast des fertigen Displays, da das Licht in den Filterelementen nur sehr geringfügig depolarisiert wird..

Die Erfindung läßt sich bei der Herstellung von Farbfiltern für Geräte, die zur Wiedergabe oder Aufnahme von ein- oder mehrfarbigen Bildern bestimmt sind, beispielsweise Videokameras oder -displays, anwenden.

Ausführungsbeispiele

Beispiel 1

Eine Glasplatte wurde mit einer Lösung von 3,75 g Dimethylester der 2,6-Dimethyl-4-(2'-nitrophenyl)-1,4-dihydropyridin-3,5-dicarbonsäure und 11,25 g Diethylester der 2,6-Dimethyl-4-(2'-nitrophenyl)-1,4-dihydropyridin-3,5-dicarbonsäure in 190 ml Methylethylketon beschichtet und getrocknet. Die trockene Schicht hatte eine Dicke von 1,2 μm. Sie wurde durch eine Maske mit quadratischen klaren Stellen von 250 μm Größe mittels einer 1000 W Quecksilberdampflampe, die mit einem Filter mit einem Durchlässigkeitsmaximum bei 360 nm versehen war, mit 160 mJ/cm² belichtet. Da die lichtempfindliche Schicht schwach klebrig war, wurde direkter Kontakt mit der Maske vermieden.

Die belichtete Schicht wurde mit einem Celluloseacetatpulver (Acetylierungsgrad 54 %, mittlere Teilchengröße 2 μm), in dessen Teilchen 30 Gewichtsprozent Perylene Pigment Red 123 (CAS-Nummer 24108-89-2) eingearbeitet worden waren, getont und der Überschuß des Toners mit einem Staubtuch abgewischt.

Zur Beurteilung des Streuverhaltens wurde die Glasplatte mit dem Filterelementmuster auf die Vorlagenplatte eines Overheadprojektors gelegt. In der Projektion erschienen die Filterelemente schwarz ohne erkennbaren Buntanteil.

Nun wurde die Glasplatte in einem Ofen 60 min lang auf 225 °C erhitzt. Nach dem Abkühlen wurde die Prüfung mit dem Overheadprojektor wiederholt. Die Filterelemente erschienen in der Projektion jetzt braun.

Schließlich wurde die Platte 10 min lang in einem zugedeckten Becherglas über Aceton mit einer Temperatur von 50 °C aufbewahrt. Die Prüfung in der Projektion zeigte nun einen kaum verschwärzlichten roten Farbton.

Beispiel 2

Es wurde wie in Beispiel 1 gearbeitet, jedoch als Toner eine Zubereitung aus 18 Gewichtsteilen Pigment Blau 15:4 (CAS-Nummer 147-14-8) und 82 Gewichtsteilen Polymethylmethacrylat mit einer Glasübergangstemperatur von 105 °C (Elvacite 2008 der Fa. Du Pont) verwendet. Während die Prüfung der frisch hergestellten Filterelemente im Overheadprojektor ein schwarzes Bild zeigte, wurde nach einer Wärmebehandlung von 60 min bei 225 °C ein rein blaugrüne Projektion beobachtet.

Beispiel 3

Es wurder wie im Beispiel 2 gearbeitet, jedoch enthielt der Toner als polymeres Bindemittel anstelle von PMMA Poly-α-methylstyrol. Auch hierbei wurde erst nach der Wärmebehandlung in der Projektion ein rein blaugrünes Bild beobachtet.

Beispiel 4

Es wurder wie im Beispiel 2 gearbeitet, jedoch enthielt der Toner als polymeres Bindemittel anstelle von PMMA ein Copolymer aus α-Methylstyrol und Vinyltoluol mit einer Erweichungstemperatur von 100 °C>

Beispiel 5

Es wurde wie im Beispiel 4 gearbeitet, jedoch mit einer Belichtung von 240 mJ cm². Man erhielt Farbfilterelemente, deren Farbdichte bei Betrachtung erkennbar höher war. Dies zeigte sich auch darin, daß die mit einem Spektralaphotometer gemessene Transmission bei 500 nm 65 % (statt 75 % wie im Beispiel 4) betrug.

Beispiel 6

Es wurde wie im Beispiel 3 gearbeitet, jedoch wurde vor der Wärmebehandlung die lichtempfindliche getonte Schicht durch die Glasplatte hindurch mit 500 mJ cm² vollflächig belichtet. Nach der Wärmebehandlung zeigten die Filterelemente in der Projektion ein rein blaugrünes Bild.

## Ansprüche

1. Verfahren zur Herstellung von ein- oder mehrfarbigen Farbfiltern durch
a) Aufbringen einer negativ arbeitenden lichtempfindlichen tonbaren Schicht auf einen transparenten Träger,
b) bildmäßige Belichtung mit einem Muster. welches der räumlichen Anordnung der Filterelemente einer Farbe entspricht,
c) Tonen der Schicht mit einem farbigen Toner.
d) ggf. Wiederholen von b) und c) mit Mustern, welche der räumlichen Anordnung der Filterelemente weiterer Farben entsprechen, unter Verwendung von Tonern der zugehörigen Farben.
dadurch gekennzeichnet, daß
1. die lichtempfindliche tonbare Schicht aus einer Zusammensetzung gebildet wird, die sich bei der Wärmebehandlung nach 3. nahezu vollständig verflüchtigt,
2. farbige Toner verwendet werden, die entweder Pulver schmelzbarer oder thermoplastischer Farbmittel sind oder neben einem Farbmittel ein thermoplastisches Bindemittel enthalten und daß
3. die ggf. mehrfach belichtete und getonte Schicht einer Wärmebehandlung unterzogen wird.
2. Verfahren nach Anspruch 1,
dadurch gekennzeichnet, daß
die Wärmebehandlung bei Temperaturen unterhalb 240 °C vorgenommen wird.

3. Verfahren nach Anspruch 1 oder 2, dadurch gekennzeichnet, daß die Dauer der Wärmebehandlung 10 bis 60 Minuten beträgt.

4. Verfahren nach einem der Ansprüche 1 bis 3, dadurch gekennzeichnet, daß die lichtempfindliche getonte Schicht zumindest nach dem bildmäßigen Belichten einen Weichmacher enthält.

5. Verfahren nach einem der Ansprüche 1 bis 4, dadurch gekennzeichnet, daß die lichtempfindliche tonbare Schicht mindestens eine Dihydropyridinverbindung enthält.

6. Verfahren nach einem der Ansprüche 1 bis 5, dadurch gekennzeichnet, daß die lichtempfindliche tonbare Schicht mindestens ein 2'-Nitrophenyldihydropyridinderivat enthält.

7. Verfahren nach Anspruch 5 oder 6, dadurch gekennzeichnet, daß die lichtempfindliche tonbare Schicht nach jedem Tonungsschritt mit einer starken Säure behandelt wird.

8. Verfahren nach einem der Ansprüche 1 bis 7, dadurch gekennzeichnet, daß die lichtempfindliche tonbare Schicht als Weichmacher Ester polyfunktioneller Carbonsäuren oder Alkohole enthält.

9. Verfahren nach einem der Ansprüche 1 bis 8, dadurch gekennzeichnet, daß die Toner als Bindemittel Celluloseacetate, Poly-$\alpha$-methylstyrol oder Polymethylmethacrylat enthalten.

10. Verfahren nach einem der Ansprüche 1 bis 9, dadurch gekennzeichnet, daß das Tonen durch Inberührungbringen mit einer farbmittelhaltigen Übertragungsschicht vorgenommen wird.

11. Verfahren nach einem der Ansprüche 1 bis 10, dadurch gekennzeichnet, daß die belichtete und getonte Schicht nach der Wärmebehandlung mit einem Lösungsmittel behandelt wird.

12. Verfahren nach Anspruch 11, dadurch gekennzeichnet, daß daß als Lösungsmittel Aceton, Butanon oder Dichlormethan verwendet werden.

13. Verfahren nach Anspruch 11 oder 12, dadurch gekennzeichnet, daß die Behandlung mit dem Dampf des Lösungsmittels erfolgt.

14. Verfahren nach Anspruch 5, 6, 9 oder 10, dadurch gekennzeichnet, daß die lichtempfindliche getonte Schicht vor der Wärmebehandlung vollflächig durch den Träger hindurch belichtet wird.